# EUROPEAN PATENT SPECIFICATION

(11) **EP 1 926 678 B1**
(45) Date of publication and mention of the grant of the patent: **20.03.2013**
(21) Application number: 06795768.8
(22) Date of filing: 24.08.2006
(51) Int. Cl.: F04B 43/04, H04R 19/01, B81C 1/00, H04R 17/02, F16K 99/00

(54) **A method of manufacturing a microsystem**
Verfahren zur Herstellung eines Mikrosystems
Procéde de fabrication de microsystéme

(30) Priority: 09.09.2005 EP 05108276
(43) Date of publication of application: 04.06.2008
(73) Proprietor: Koninklijke Philips Electronics N.V., 5621 BA Eindhoven (NL)
(72) Inventor: LANGEREIS, Geert, 52066 Aachen (DE); WEEKAMP, Johannes Wilhelmus, 52066 Aachen (DE); GIESBERS, Jacobus Bernardus, 52066 Aachen (DE)
(74) Representative: Verweij, Petronella Danielle
(86) International application number: PCT/IB2006/052943
(87) International publication number: WO 2007/029132

(56) References cited:
- WO-A-01/09598
- WO-A-99/19717
- US-A1- 2002 185 184

## Description

The invention relates to a method of manufacturing a microsystem provided with a space.

Such a method and microsystem are known from the publication Ramadoss, R. et al., "Fabrication, Assembly, and Testing of RF MEMS Capacitive Switches Using Flexible Printed Circuit Technology. " IEEE Transactions on Advanced Packaging, Vol. 26, No. 3, August 2003, pp. 248-254. With the known method, a copper-clad substrate layer is provided. The copper cladding is polished so as to make it flatter. Following that, coplanar waveguides are defined in the copper cladding, using photolithography and etching steps. Then, a layer of polymer is applied to the substrate and subsequently patterned, which polymer forms the dielectric for the bottom electrode. Furthermore, a polyimide membrane is provided in the known method, on which a copper layer is formed. The copper layer is patterned, using photolithography and etching steps, thereby forming the top electrode. The polyimide membrane is patterned by means of a laser so as to form openings in the membrane. The method furthermore comprises a step in which an adhesive layer is provided for defining the spacing between the bottom electrode and the top electrode. With the known method, an MEMS switch is obtained by stacking the polyimide membrane on the substrate, albeit separated therefrom by the adhesive layer. The alignment of the various layers takes place by means of a fixation element comprising reference pins. Finally, the various layers are interconnected by exerting a pressure on the layers at an elevated temperature.

The problem with the known method is that it is a relatively complex method.
WO 99/19717 describes a laminate microstructure device and a method for the production of such. WO 01/09598 describes a fluidic interconnect, an interconnect manifold and microfluidic devices for internal delivery of gases and application of vacuum and US 2002/0185184 describes a microfluidic reactor for chemical and biological synthesis built from several layers.

According to the invention, this object is achieved by a method of manufacturing a microsystem provided with a space, which method comprises the following steps:
- providing a set of at least two electrically insulating flexible foils, wherein the individual foils have substantially the same thickness, and wherein a conductive layer is present on at least one side of at least one foil, and wherein said conductive layer is suitable for use as an electrode or a conductor;
- patterning the conductive layer so as to form an electrode or a conductor;
- patterning at least one foil, in such a manner that an opening is formed, which opening forms the space of the microsystem;
- stacking the set of foils, thus forming the microsystem; and
- joining the foils together, with the foils being bonded together at those positions where, when two adjacent foils are in contact with each other, at least one conductive layer between the foil material of two adjacent foils has been removed, wherein stacking of the foils takes place by winding at least one foil onto a first reel.

With the method according to the invention, the degree of regularity is greater than with the known method. For example, if layers or spaces having a thickness different from the thickness of one foil are to be realized in a device, a multitude of foils can be stacked together in a simple manner. A foil having a different thickness is not needed, therefore. All the dimensions in the direction perpendicular to the foils will thus at all times amount to a multitude of the thickness of one foil. Consequently, the method according to the invention is less complex and thus cheaper.

An additional advantage of the method according to the invention is the fact that it is a universal method. This means that the method is a modular method, and that it is suitable for more applications than the known method, therefore.

An advantage of using foils having a uniform thickness is the fact that it is possible to implement a device in any subset of foils in a stack comprising several foils. For example, if A is a pump to be designed comprising 5 layers of foil, and B is a sensor to be designed in a channel comprising 3 layers of foil, many different ways of placing the designs A and B in a stack of 30 layers of foil are available to the designer.

An improved embodiment of the method according to the invention is characterized in that a set of foils is provided, with the individual foils comprising the same foil material. The advantage of this aspect is that only one type of foil needs to be used, which makes it possible to use foil from one and the same roll. This renders the method even less complex and consequently even more inexpensive.

The method is preferably characterized in that at least three electrically insulating flexible foils are provided. This is advantageous in particular if more complex structures are to be formed, in which case two flexible foils do not suffice. Another embodiment of the method according to the invention is characterized in that at least four electrically insulating foils are provided. When at least four foils are used, more design possibilities are available to the designer. Thus, the designer may form a freely suspended flap, which functions as a shut-off valve of the space. Since two layers are present between the outer foils, there will be no adhesion at the position where the flap is adjacent to the space when the foils are being joined together, so that the flap will continue to be freely suspended. The flap can be opened or closed by means of a liquid flow, possibly also by means of electrostatic actuation.

One embodiment of the method according to the invention is characterized in that a movable element is formed of at least one foil in the microsystem, which movable element is attached to the microsystem on at least one side, wherein the movable element is selected from the group comprising a movable mass, a movable valve and a movable membrane, and wherein the movable element is present at one side of the space. Such an aspect makes it possible to form active microfluidic devices and MEMS devices. In the case of active microfluidic devices it is important to block the flow of a gas or a liquid in a particular direction and/or maintain the flow in another direction. In the case of MEMS devices, a conversion of a movement of one element into an electrical signal on an electrode is usually concerned or, quite the reverse, of an electrical signal on an electrode into a movement of an element.

Another embodiment of the method according to the invention is characterized in that the microsystem is provided with a sensor which is formed in a conductive layer on a foil near the space for measuring a quantity in said space. A sensor is likewise an important building block in MEMS devices and microfluidic devices.

A first main variant of the above embodiments of the method is characterized in that the microsystem to be manufactured comprises an MEMS device. A further elaboration of this main variant of the method is characterized in that the microsystem that is manufactured is a microsystem from the group comprising an MEMS capacitor microphone, an MEMS pressure sensor, an MEMS accelerometer. These devices are important building blocks in larger electronic devices, which can be produced in a relatively inexpensive manner by means of the method. Other devices are also possible, of course.

A second main variant of the above embodiments of the method is characterized in that the microsystem to be manufactured comprises a microfluidic device. A further elaboration of this main variant of the method is characterized in that the microsystem that is manufactured is a microsystem from the group comprising a microvalve, a micropump and a µTAS element. These devices are important building blocks in microfluidic devices, which can be produced in a relatively inexpensive manner by means of the method. Other devices are also possible, of course.

A further improved embodiment of the method according to the invention is characterized in that said patterning is carried out by means of a laser, whether or not in combination with a mask. This aspect makes it possible to realize a highly controlled removal of the conductive layer and/or the foil material. In addition, it is very advantageous that the space need not be cleared through selective etching of sacrificial materials, which is necessary when conventional methods are used.

A further improved embodiment of the method according to the invention is characterized in that said patterning is carried out by using a selection from the following steps:
- leaving the conductive layer and the foil intact;
- removing the conductive layer so as to expose the foil;
- removing the conductive layer and part of the foil, so that a thinner foil remains; and
- completely removing the conductive layer and the foil so as to form the space.

The above four basic steps provide essentially four main areas, which, when combined, can provide the desired pattern in the foils:
- areas where both the foil and the conductive layer have not been removed,
- areas where only the conductive layer has been removed (for example so as to form a connection with the adjacent foils),
- areas where the conductive layer but also part of the foil has been removed ( for example so as to manipulate the flexibility of the foil), and
- areas where both the conductive layer and the foil have been removed (for example so as to create a space).

An advantageous embodiment of the method according to the invention is obtained if said stacking of the foils takes place by winding at least one foil on a first reel. A major advantage of this embodiment is that aligning the foils will be easier when the foils are being stacked.

An improved embodiment of the latter method is characterized in that the method is carried out in a process in which the foil is unwound from a second reel or roll upon being wound onto the first reel. The major advantage of this aspect is that the method can be carried out in a continuous process, so that the method will be easier to automate.

A further improvement is obtained if said patterning of the conductive layer and the foil takes place at at least one position selected from the following possibilities: on or near the first reel, between the first and the second reel, and on or near the second reel or roll. Depending on the question whether a conductive layer is present on both sides of the foil, a person skilled in the art can choose where he wants said patterning to take place.

The method according to the invention is preferably characterized in that said joining of the foils is carried out by exerting a pressure on the stacked foils at an elevated temperature, with the pressure being exerted in a direction perpendicular to the foils. As a result, the foils will fuse together and the device will take its definitive shape.

A further elaborated embodiment of the latter method is characterized in that the required pressure on the foils adjacent to the space in the structure is obtained through the application of an elevated pressure in said space. The advantage of this aspect is that foils are pressed into better abutment with adjacent foils at places where they are adjacent to a space, so that a better adhesion of said foils will be obtained.

A preferred embodiment of the method according to the invention is characterized in that an opening is formed in the stack of foils so as to provide access from one side of the microsystem to a conductive layer that is connected to an electrode of the microsystem. In this way a contact area is provided, as it were, for electrically connecting the electrode.

A further elaborated embodiment of the method according to the invention is characterized in that the microsystem is separated from the stack after fusion of the foils has taken place. The separate device thus obtained has this advantage that it can be traded or be incorporated in a product.

Another embodiment of the method according to the invention is characterized in that the material for the conductive layer is selected from the group comprising aluminum, platinum, silver, gold, copper, indium tin oxide, and magnetic materials. These materials are very suitable for use as electrodes and/or conductors. Indium tin oxide moreover has the advantage of being optically transparent, which is advantageous when used in microfluidic devices.

The method according to the invention is preferably characterized in that the foil material is selected from the group comprising polyphenyl sulphide (PPS) and polyethylene terephthalate (PET). These materials are quite suitable for use as an electrically insulating foil material.

A preferred embodiment of the method is characterized in that the foil that is used has a thickness between 1 µm and 5 µm. The advantage of using a foil thickness in that range is that a reasonable degree of flexibility of the foils is obtained, as well as a reasonable degree of accuracy with which the dimensions in the device in a direction perpendicular to the foils can be fixed.

The above and further aspects of the method according to the invention will now be explained in more detail with reference to the figures, in which:
Fig. 1 is a schematic representation of a part of the method, which shows the manner in which four different areas are created on a foil with a conductive layer present thereon;
Fig. 2 shows the manner in which foils can be automatically aligned and also patterned;
Fig. 3 is a schematic representation of an embodiment of a part of an arrangement for carrying out the method according to the invention;
Fig. 4 shows a photo of an actual arrangement for carrying out the method;
Fig. 5 shows a stack of eight foils forming an MEMS capacitor microphone structure;
Fig. 6 shows a first exemplary microsystem viz. an MEMS capacitor microphone, after bonding of the foils of figure 5;
Fig. 7 shows a membrane of an MEMS capacitor microphone which has been thinned in certain places;
Fig. 8 shows a second exemplary microsystem viz. an MEMS pressure sensor;
Fig. 9 shows a third exemplary microsystem viz. an MEMS accelerometer;
Fig. 10 shows a fourth exemplary microsystem , viz. an electrostatically driven microvalve;
Fig. 11 is an expanded 3-dimensional illustration of the electrostatically driven microvalve of Fig. 10;
Fig. 12 shows a fifth exemplary microsystem viz. an electrostatically driven micropump;
Fig. 13 is an expanded 3-dimensional illustration of the electrostatically driven microvalve of Fig. 12;
Fig. 14 shows a sixth exemplary microsystem viz. a µTAS element;
Fig. 15 is an expanded 3-dimensional illustration of the µTAS element of Fig. 14;
Fig. 16 shows an MEMS pressure sensor which also functions as part of a package of an integrated circuit, in which soldering wires are used for the connections between the MEMS pressure sensor and the integrated circuit;
Fig. 17 shows an MEMS pressure sensor which also functions as part of a package of an integrated circuit, in which flip-chip technology is used.

Hereinafter a detailed description of the invention will be given. As already said before, the invention relates to a method of manufacturing a microsystems. A great many embodiments of the microsystem according to the invention are possible, which embodiments are of a diverse nature. Nevertheless, all these embodiments have a common factor, viz. the fact that they are built up of a joined-together stack of pre-processed electrically insulating foils that are provided with a conductive layer on at least one side thereof.

The method of producing the microsystem comprises several substeps:
- applying a conductive layer to at least one side of the foils (two sides is also possible, therefore, and is even preferable in some cases);
- pre-processing the foils;
- stacking the foils, thus forming the microsystem;
- bonding the foils; and
- separating the microsystem from the stack of foils.

Said pre-processing of the foils consists of a selection of the following steps:
- leaving the conductive layer and the foil intact;
- removing the conductive layer so as to expose the foil;
- removing the conductive layer and part of the foil, so that a thinner foil remains; or
- completely removing the conductive layer and the foil.

The combination of the above steps makes it possible to realize a large number of different patterns both in the conductive layer and in the foil, which enables a designer to create many different structures. Preferably, the removal of the material in the above steps is carried out by means of a laser (for example an excimer laser). A major advantage of using a laser is that said removal can take place outside a clean room, in contrast to removal by etching, for example. Several possibilities are open to a person skilled in the art in this connection. A person skilled in the art may use a wide parallel laser beam in combination with a mask, or he can scan the surface of the foil with a single laser beam and at the same time modulate the intensity of the beam. In that case a person skilled in the art can choose again between modulating either the intensity or the duty cycle of a series of brief light pulses.

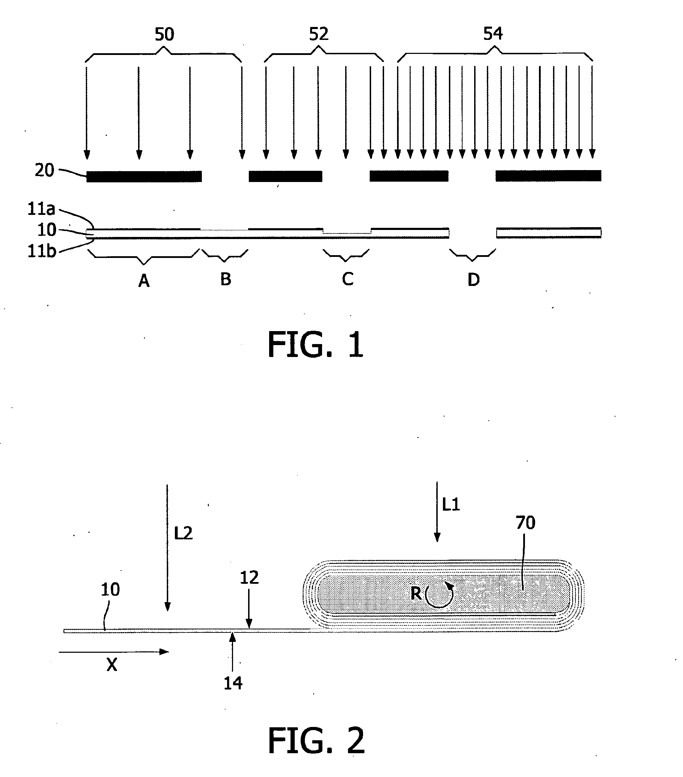

Fig. 1 shows the manner in which said pre-processing by means of a collimated laser beam and a mask is carried out. The figure shows three laser beams 50, 52, 54, each having a different intensity (running up from the left to the right in this example). The mask 20 partially stops the laser beams 50, 52, 54. Present below the mask 20 is the foil 10, which is provided with a conductive layer 11a, 11b on both sides in this example. It is also possible to use only one conductive layer 11a, of course. Preferably, the conductive layers 11a, 11b comprise aluminum, platinum, silver, gold, copper, indium tin oxide or magnetic materials.

In area A the mask 20 screens the foil 10, so that the low-energy beam 50 cannot reach the foil 10. The foil 10 remains unaffected. In area B the laser beam 50 does reach the foil, but the energy of the laser beam 50 is such that only the conductive layer 11a is removed (and possibly also a thin layer of the foil material, but in any case only to a negligible extent). When the energy level is further increased, a substantial part of the foil material 10 will be removed as well, so that an area C comprising a thinner foil is created. Finally, holes can be formed and the foil 10 by means of a high-energy laser beam 54. Such a hole is shown at the area D in the figure. In the foregoing, mention is made of increasing the energy level of the laser beam, which can be understood to mean that either the intensity or the duration of the laser pulse is increased. After all, the only thing that matters is that the extent to which the material is removed depends only on the amount of energy that is applied. Manipulating the duty cycle of a pulsed laser beam is easier than manipulating the light intensity of a laser beam for that matter.

After the foils 10 have been pre-processed, stacking can take place. Preferably, this is done by winding a foil onto a reel. Such an arrangement is shown in Fig. 2. The pre-processed foils 10 are in fact contained in one and the same tape in that case. When the foil material consists of Mylar, this is available inter alia in the form of a rolled-up tape having a thickness of 1 µm and a width of 2 cm. Said foil is also available with a 20 nm thick layer of aluminum present thereon (on one side or on both sides), which layer is suitable for use as the conductive layer in microsystems. In the present description, however, only separate foils 10 will be discussed. In this arrangement both the front side and the rear side of the foil 10 can be pre-processed. Also in this case, this may be done by means of a laser beam, for example at positions L1, L2. The foil 10 moves in the direction X during said winding, being wound onto a reel 70, which has two flat sides in this example, in the direction of rotation R. A first laser beam at position L1 is directed at the foil that is present on the reel 70, so as to pre-process the foil 10 at the rear side 14 of the foil 10. A second laser beam at position L2 is directed at the foil that is not present on the reel 70 yet ,so as to pre-process the foil 10 at the front side of the foil 10. It is not essential that the foil 10 be provided with a conductive layer on both sides 12, 14, and consequently it is not essential that the foil 10 be pre-processed on two sides 12,14, either. In some applications it may be useful, however, as will become apparent in the discussion of some of the embodiments of the microsystem hereinafter.

A major advantage of winding a foil 10 onto a reel 70 is that this makes it much easier to align the foils 10. The stacking of preprocessed foils 10 (which may or may not be done by winding the foils onto a reel 70) makes it possible to create spaces, cantilevers and membranes. Elements of this kind are usually required in microsystems such as MEMS devices and microfluidic devices.

After the foils 10 have been stacked, they can be bonded together, using an elevated pressure and an elevated temperature. When foils 10 are stacked by being wound onto a reel 70, said bonding can simply take place while the foils 10 are being wound onto the reel. In fact there are three possibilities when bonding a stack of foils:
- the foil material of one foil makes direct contact with the foil material of the other foil, resulting in a strong bond;
- the foil material of one foil makes direct contact with the conductive layer of the other foil, resulting in a weak bond;
- the conductive layer of one foil makes direct contact with the conductive layer of the other foil, in which case a bond is not obtained.

If no pressure is exerted, the foils 10 will not bond together. This effect can be utilized for making valves. In particular when of foil 10 is adjacent to a space, it will not experience any pressure because of the flexibility of the foils. In fact the foil 10 will continue to be freely suspended. This aspect will come up again in the discussion of embodiments of the microsystem according to the invention hereinafter.

When it is nevertheless desirable that foils adjacent to a space be bonded, this can be achieved by using an elevated pressure in said space, for example. Said pressure may be a gas pressure but also a liquid pressure.

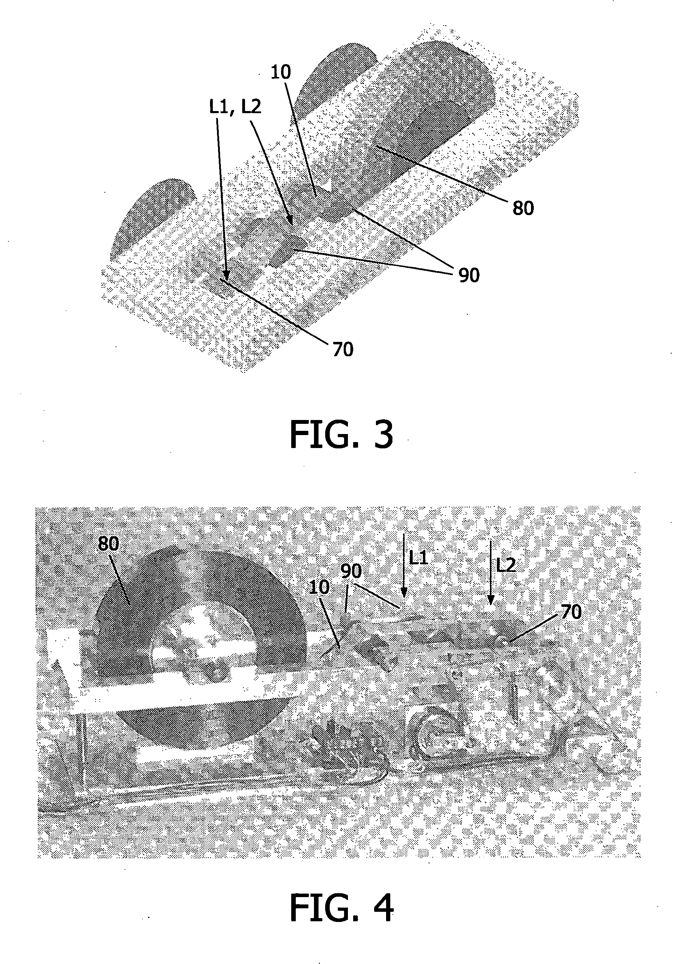

Fig. 3 is a schematic representation of an embodiment of a part of a possible arrangement for carrying out the method. Fig. 4 shows a photograph of an actual arrangement for carrying out the method. In the arrangement as shown, the foil 10 is unwound from a reel 80 and at the same time wound onto the aforesaid reel 70 via auxiliary rollers 90. The figure furthermore shows the possible positions of the laser beams L1, L2.

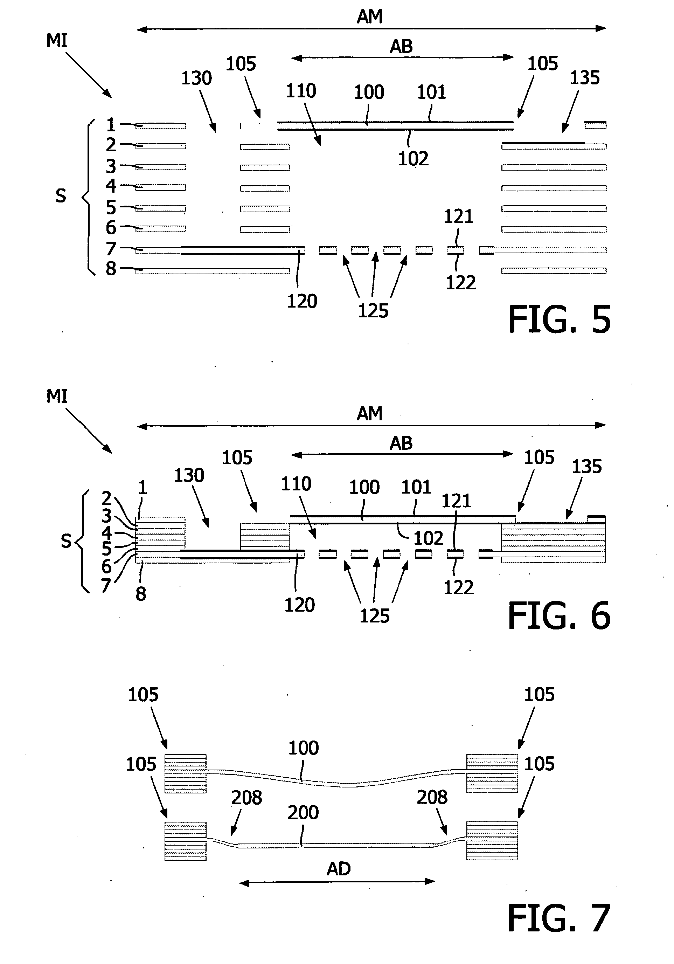

Fig. 5 and Fig. 6 show a first microsystem. Both figures illustrate an MEMS capacitor microphone MI, which is built up of a stack S of preprocessed foils. In Fig. 5, the MEMS microphone MI is shown in expanded form prior to the bonding of the foils. In Fig. 6 the foils are bonded together. The foil stack S may be placed on the substrate so as to make the whole more manageable. The MEMS microphone MI comprises a movable membrane 100 adjacent to a space 110, which is anchored in several areas 105. In the sectional views of the figure, said areas appear to be separated, but preferably said area 105 completely surrounds the space 110.

The membrane is provided with a conductive layer on both sides 101,102. In fact only one conductive layer is needed on one side (in this example the bottom side 102) for forming an electrode in the membrane 100, but the advantage of using a second conductive layer on the other side 101 is that warping of the membrane 100 will occur less easily. Present within the space, spaced from the membrane 100 by some distance, is a backplate 120, which is likewise provided with a conductive layer on both sides 121,122. In fact only one conductive layer is needed on one side (in this example the upper side 121) for forming an electrode in the backplate 120, but also in this case the advantage of using a second conductive layer on the other side 122 is that warping of the backplate 120 will occur less easily. The electrodes of the membrane 100 and the backplate 120 jointly form a capacitor. The spacing between the capacitor plates amounts to five foils in this example. When foils having a thickness of 1 µm are used, the spacing will amount to 5 µm. If the MEMS microphone MI has a surface area AM of 2x2mm², the surface area AB of the membrane 100 may come close to said value (the dimensions are not to scale in the drawing). In other words, the surface area in the MEMS microphone MI can be utilized more efficiently than with the known MEMS microphones, such as the MEMS microphone that is known from the publication by Udo Klein, Matthias Müllenborn and Priming Romback "The advent of silicon microphones in high-volume applications", MSTnews 02/1, pp. 40-41. When the Mylar tape having a width of 2 cm is used, it is possible to produce ten MEMS microphones alongside each other in an almost infinite number of rows (determined only by the length of tape on the reel).

The backplate 120 is preferably provided with openings 125 for releasing differences in air pressure that arise in the space 110 during vibration of the membrane 100 induced by sound waves. The operation of the MEMS microphone is as follows. Sound waves set the membrane 100 in motion (the membrane will start to oscillate). As a result, the spacing between the membrane 100 and the backplate 120 will start to oscillate as well, which in turn leads to oscillation of the capacitance of the capacitor (formed by the conductive layers on the membrane 100 and the backplate 120). These capacitance changes can be electrically measured and are at the same time a measure of the sound waves on the membrane 100.

The MEMS microphone MI is provided with contact holes 130, 135 that function to provide access to the capacitor plates (electrodes) of the membrane 100 and the backplate 120. The upper electrode on the membrane 100 is positioned partially on foil 1 and partially on foil 2. In this way the electrode will become accessible from the upper side via the contact hole 135.

In the example of Fig. 5 and Fig. 6, the MEMS microphone MI comprises a stack S of eight foils 1,2,3,4,5,6,7,8. A different number of foils is also possible, however. This depends in particular on the desired vertical dimensions and spacing values of the microphone. The same applies to all the examples of the microsystem that are discussed in the present description.

In case the tensile stress of the membrane 100 is not sufficient, as a result of which the deflection profile of the membrane is not optimal, the designer may elect to make the membrane 100 thinner at the edges. This is shown in Fig. 7. Both membranes 100 are anchored in areas 105. The upper membrane 100 in the figure does not comprise any thinned areas and deflects most strongly in the center on account of the sound pressure. The lower membrane 200 in the figure, on the other hand, does comprise thinned areas 208 at the edge, as a result of which the membrane 200 exhibits the same extent of the deflection over a relatively large area AD. The consequence of this aspect is that a larger electrical signal on the capacitor (made up of the conductive layers on the membrane 100 and the backplate 120) of the MEMS microphone MI can be measured with the same sound pressure. The forming of such thinned areas 208, using the method according to the invention, is fairly simple for that matter (partial removal of the foil, for example by means of a laser), whereas this is very difficult in silicon technology.

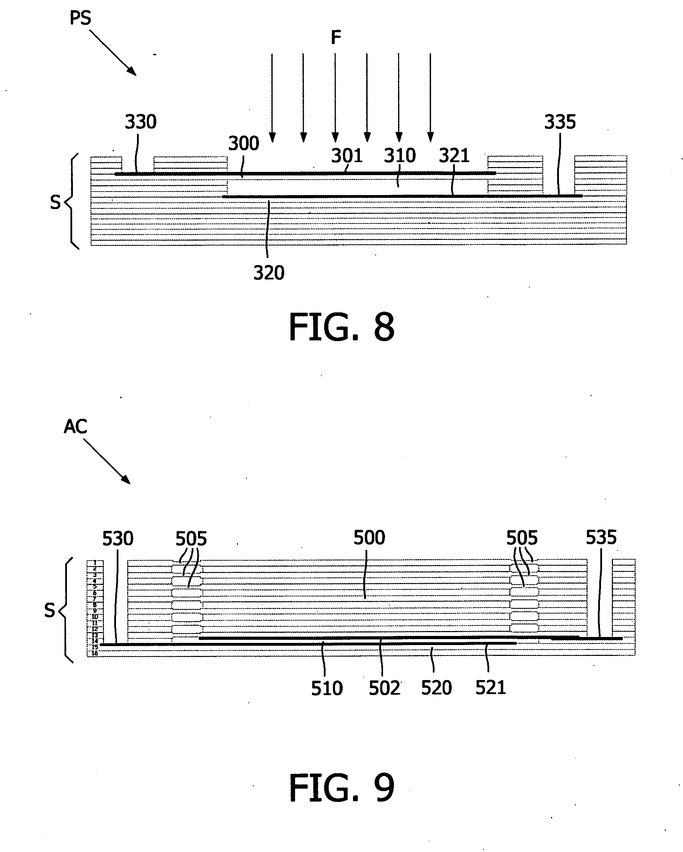

Fig. 8 shows a second microsystem. This figure shows an MEMS pressure sensor PS built up of a stack S of preprocessed foils. In fact, such a pressure sensor PS is a special microphone. It exhibits a great deal of resemblance with the MEMS microphone MI, therefore. The MEMS pressure sensor PS comprises a movable membrane 300, which closes a space 310 in the MEMS pressure sensor. At the upper side 301, the membrane is provided with a conductive layer for forming an electrode. Present at the other side of the space 310 is a second electrode 321 in the form of a conductive layer on a closed backplate 320. This is at the same time the characteristic difference with the microphone, the space of the MEMS pressure sensor PS is closed and the space of the MEMS microphone MI is in communication with the surrounding atmosphere.

In this example, the backplate 320 comprises several foils. The advantage of this is that the backplate 320 will be relatively rigid in comparison with the movable membrane 300. The number of foils may vary, however. The designer has freedom of choice in selecting this number. For example, if the designer elects to place the foil stack S on a substrate, the number of foils for the backplate 320 can be reduced.

The operation of the MEMS pressure sensor is as follows. A force F on the membrane 300 (which is a measure of the pressure difference between the space 310 and the free space above the membrane 300) will cause the membrane to deflect. This causes the spacing between the membrane 300 and the backplate 322 change, as a result of which the capacitance of the capacitor (formed by the conductive layers on the membrane 300 and the backplate 320) will change as well. This capacitance change can be electrically measured and is at the same time a measure of the force F on the membrane 300 (and thus the pressure).

The MEMS pressure sensor PS is provided with contact holes 330, 335 that function to provide access to the capacitor plates (electrodes) of the membrane 300 and the backplate 320.

Fig. 9 shows a third microsystem. This figure shows an MEMS accelerometer AC built up of a stack S of preprocessed foils. An accelerometer can be made up of a seismic mass 500 on a resilient element 505. The movement of the mass 500 can be measured as a change in the capacitance of parallel plates 505, 521 with a space 510 present therebetween. A possible embodiment is shown in Fig. 9. It is not possible to separate a piece of foil completely from the remaining foil during manufacture of the MEMS accelerometer AC (especially during the preprocessing of the foils while they are still contained in the tape). A solution is to use thin anchors in all foil layers of the seismic mass 500 in the form of locally thinned portions 505 in the foil. In this example, the mass 500 is made up of the foils 1 - 13. The foils will bond poorly during manufacture, because of the presence of the space 510 (a bond is not obtained if no pressure is applied). A solution is to implement the conductive layers on both sides of the space 510, in such a manner that they are positioned opposite each other. As a result, the foils adjacent to the space 510 will not bond anyhow. However, it is now possible to use a mechanical soft heater, which compresses all the layers in such a manner that the conductive layers make contact with each other and the other layers nevertheless experience pressure, causing them to bond. After said bonding of the foils, the resilient elements 505 cause the mass 500 to spring back to its original position. The MEMS accelerometer AC is provided with contact holes 530, 535 that function to provide access to the electrodes 502, 521. The upper electrode 502 is positioned partially on the foil 13 and partially on the foil 14. In this way the electrode 502 becomes accessible from the upper side for connection.

The operation of the MEMS accelerometer AC is as follows. When the accelerometer experiences an acceleration force perpendicular to the foils, the seismic mass 500 will move upwards or downwards, thereby changing the spacing between the electrodes 502, 521. Said change results in a change in the capacitance between said two electrodes, which latter change can be electrically detected.

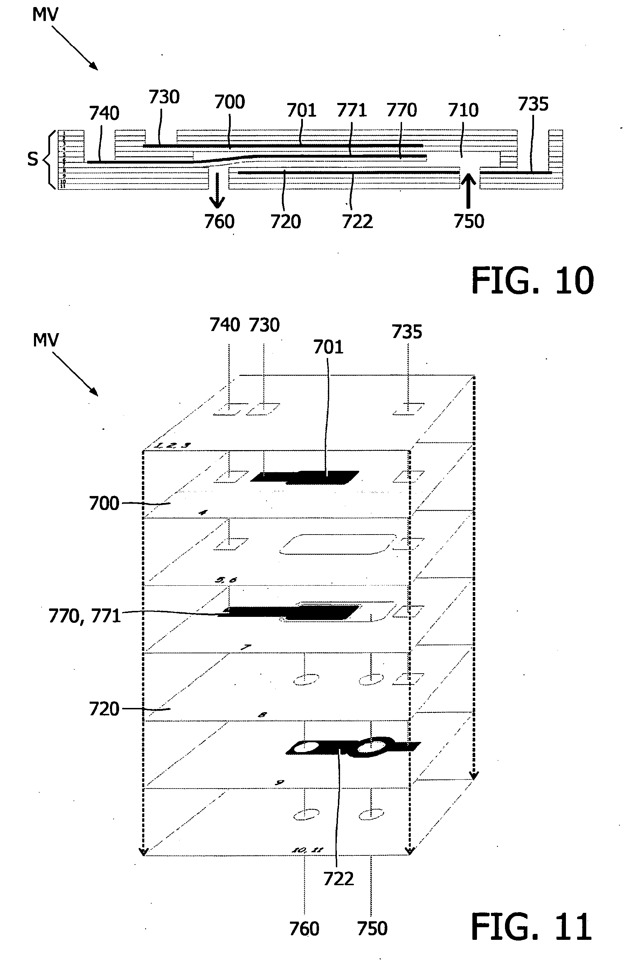

Fig. 10 and Fig. 11 show a fourth microsystem. These figures illustrate a possible implementation of a microvalve MV built up of a stack S of preprocessed foils. In Fig. 10, the foil stack S is already bonded, and Fig. 11 shows an expanded view of the microvalve MV. The microvalve MV is provided with a space 710 having an inlet 750 and an outlet 760. In this example, the outlet 760 is provided with a movable valve 770 in the form of a foil that is anchored at one side. Present on the movable valve 770 is an electrode in the form of a conductive layer 771. At the upper side of the space 710, a first electrode 701 is present in a foil 700 adjacent to said space 710. The first electrode is used for opening the valve 770. At the lower side of the space 710, a second electrode 722 is present in a foil 720 adjacent to said space 710.

The valve is a cantilever valve, as it is adjacent to the space 710, as a result of which it does not experience any pressure upon joining of the foils. The microvalve MV can be used with gases as well as with liquids. One might wonder in relation to Fig. 10 why the first three foils 1,2,3 bond. From Fig. 11 it becomes apparent, however, that only a small area adjacent to the space 710 is concerned. The area surrounding the space 710 will bond sufficiently, therefore. The microvalve MV is provided with contact holes 730, 735, 740 that function to provide access to the electrodes 701, 771, 722.

The microvalve MV operates as follows. When a voltage is applied between the contacts 730 (first electrode 701) and 740 (electrode 771), the valve will be electrostatically pulled towards the upper electrode 701, causing it to open. When a voltage is applied between the contacts 735 (second electrode 722) and 740 (electrode 771), the valve 770 will be electrostatically pulled towards the lower electrode 722, causing it to close.

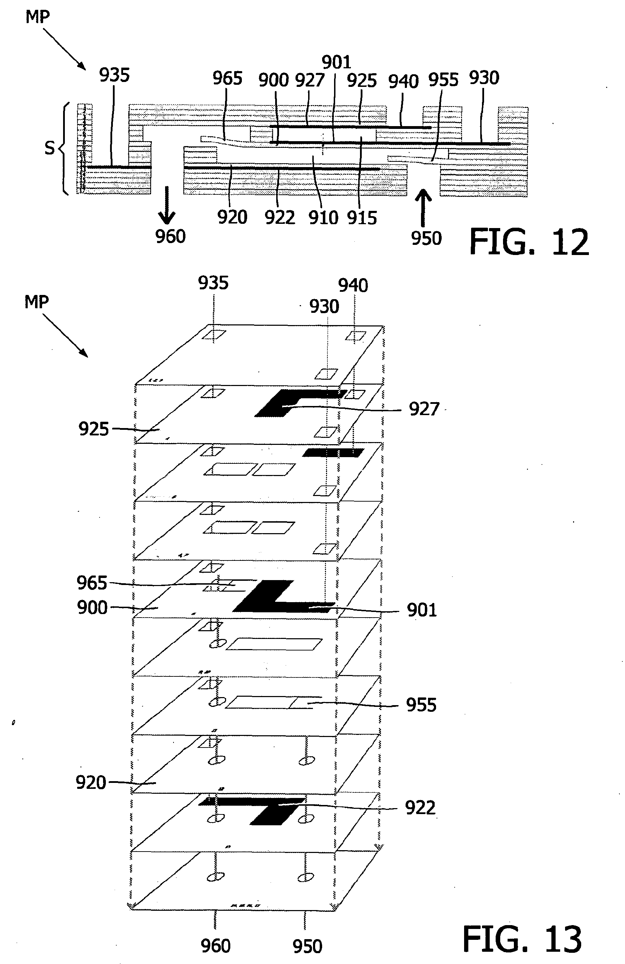

Fig. 12 and Fig. 13 show a fifth microsystem. The figures illustrate a possible implementation of a micropump MP built up of a stack S of preprocessed foils. In Fig. 12, the foil stack S is already bonded, and Fig. 13 shows an expanded view of the micropump MP. The micropump MV is provided with a first space 910 having an inlet 950 and an outlet 960. The first space 910 is provided with a passive valve 955 at the inlet 950 and a passive valve 965 at the outlet, which valves are so arranged that they only open to one side for passing a gas or a liquid. At the upper side, the first space 910 is provided with a movable membrane 900 in the form of a foil on which a first electrode 901 is present. At the bottom side, the first space 910 is provided with a second electrode 922, which is present at the bottom side of a foil 920 adjacent to the first space 910. Present above the membrane 900 is a second space 915, which is preferably fully closed. At the upper side of said second space, a third electrode 927 is present on a foil 925 adjacent to said second space 915. In Fig. 13, the electrode 927 is drawn at the upper side of the foil 4 for the sake of clarity, but in reality it is located at the bottom side. The micropump MP is provided with contact holes 930, 935, 940 that function to provide access to the electrodes 901, 922, 927.

The micropump MP operates as follows. When a voltage is applied between the third electrode 927 (via contact 940) and the first electrode 901 (via contact 930), the membrane will be electrostatically pulled towards the third electrode 927, causing the second space 915 to decrease in volume. As a result, the first space 910 will increase in volume, as a result of which an underpressure is generated in the first space 910. This causes the valve 955 at the inlet 950 of the space to open, and gas or liquid will be sucked into the space 910. When a voltage is applied between the second electrode 922 (via contact 935) and the first electrode 901 (via contact 930), the membrane 900 will be pulled towards the second electrode 922, causing the second space 915 to increase in volume and the first 910 to decrease in volume, as a result of which an overpressure is generated in the first space 910. This causes the valve 965 at the outlet 962 open, and gas or liquid will be expelled from the space 910. The second electrode 922 is optional. In the absence of a voltage on the third electrode 927, the membrane 900 will automatically return to the original position. The electrodes surrounding the second space 915 may also be arranged and used as resistors, enabling the second space 915 to expand via resistive heating.

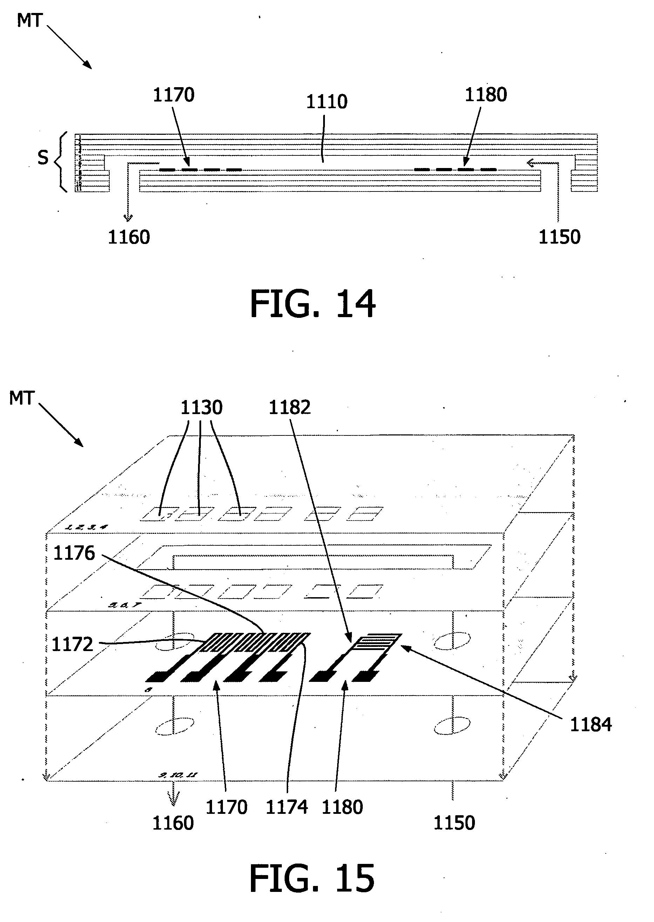

In addition to micropumps and microvalves, also sensors can be formed in the microsystem. This makes it possible to produce a so-termed µTAS element (micro total analysis system). Fig. 14 and Fig. 15 show this sixth microsystem. The figures show a possible implementation of a µTAS element MT built up of a stack S of preprocessed foils. In Fig. 14, the foil stack S is already bonded, and Fig. 15 shows an expanded view of the µTAS element MT. The µTAS element MT is provided with a first space 1110 having an inlet 1150 and an outlet 1160. Two different sensors, viz. a flow sensor 1170 and a conductivity sensor 1180, are located adjacent to the space 1110 in this example. The sensors are present in the conductive layer on the foil that is adjacent to the space. In this example, the flow sensor 1170 comprises three series-connected resistive meander structures, one meander structure 1176 being used for heating and the other two meander structures 1172, 1174 being used for measuring the resistance of said meander structures, so that they are used as temperature sensors.

In this embodiment, a conductivity sensor 1180 is furthermore disposed adjacent to the space 1110. Said conductivity sensor 1180 comprises two comb structures 1182, 1184. In one embodiment, the impedance measured between the two comb structures 1182, 1184 is a measure of the amount of charged particles present in the space 1110, which, in a liquid, indicates the ion strength. The µTAS element MT is furthermore provided with contact holes 1130 that function to provide access to the electrodes of the sensors 1170, 1180.

In principle such flow sensors (a combination of a heating element 1174 and two temperature sensors 1172, 1174) and conductivity sensors 1180 are generally known, but they can be manufactured in a very simple manner by using the method according to the invention. If the µTAS element is used for liquids having a high pH value, the use of pure aluminum on the foils is not the best choice, because the aluminum is susceptible to attack. To make the sensors more inert, the sensors may be plated with, for example, copper (Cu), silver (Ag) or gold (Au). It is also possible to use a gold-plated tape from the outset.

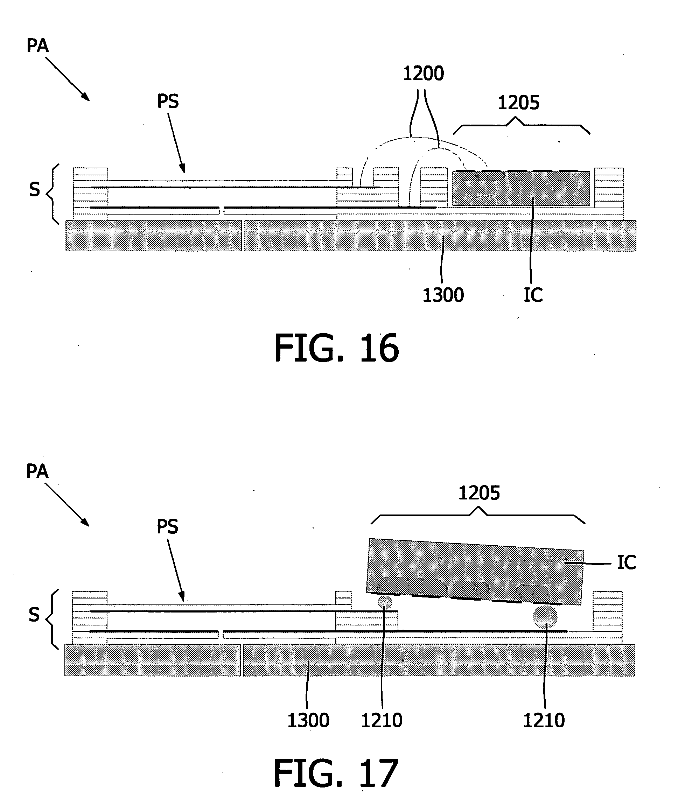

Fig. 16 and Fig. 17 show another important advantage of these microsystems. The fact is that it is also possible to manufacture the microsystem according to the invention in such a manner that it also forms part of the package PA of an integrated circuit IC ( which may or may not be connected to the microsystem). Fig. 16 and Fig. 17 show by way of example a capacitive pressure sensor PS having an opening 1205 in the foil stack S. It is also possible to use a different microsystem, of course, for example an MEMS microphone. Present in the opening 1205 is the integrated circuit IC. In this example, the integrated circuit IC is connected to electrodes of the pressure sensor PS. The connections are formed by metal wires 1200 (e.g. gold or copper whilst) in Fig. 16 and by solder balls in Fig. 17. The second possibility is also referred to as flip-chip technology. Both in Fig. 16 and in Fig. 17 the microsystem PS is provided on a substrate 1300. However, it is also possible not to use a substrate 1300 but, for example, a much thicker foil stack S.

From the examples in the present disclosure it can be concluded that the invention can be used for manufacturing microsystems such as MEMS devices and microfluidic devices in an inexpensive manner. The enumeration of embodiments is by no means exhaustive. The products obtained by using the present invention can be used both in consumer electronics and in medical applications in which cooperation between electronic devices and the environment is necessary. The cost of these products is even so low that they may be used as disposable products. A number of concrete applications of the invention are listed below:
- MEMS microphones for mobile telephones and PDAs;
- Micropumps and fluid treatment in chemical analysis systems; and
- Pressure sensors in tires.

As regards the selection of the foil material, many materials may be used, for example polyvinyl chloride (PVC), polyimide (PI), Poly(ethylene terephthalate) (PET), poly(ethylene 2,6-naphthalate) (PEN), polystyrene (PS), polymethyl methacrylate (PMMA), polypropylene, polyethene, polyurethane (PU), cellophane, polyester, parilene. In fact it amounts to this that any material that meets a number of criteria may be used. Attention should be paid that:
- the thickness of the foil determines the vertical resolution;
- the foil, as the basic material, must be manageable, preferably supplied on a roll;
- the foil is capable of being metallized;
- the metallized foil is capable of being preprocessed, preferably by means of a laser;
- the foil can be bonded after stacking, preferably by using heat and pressure;
- the material can be melted at "low" temperatures (<300 degrees); and
- the foil stack, after stacking and bonding, possesses the properties that are required for the microsystem.

An important note in this connection is that the bonding of the foils preferably takes place at a temperature just below the melting point of the foil material. For example, if polyethylene terephthalate (PET) is used as the foil material (having a melting point of 255°C), a temperature of, for example, 220°C will be used.

More in particular, the foil material must be selected on the basis of the properties required for the application in question, viz.: temperature stability, shape stability, pressure resistance, optical and chemical properties.

Finally, inorganic, insulating foils may be used, such as mica.

All the figures in the present description are merely schematic representations, which are moreover not drawn to scale. They are intended by way of illustration of the embodiments aimed at by the invention and to provide technical background. In reality, the shapes of boundary faces may differ from those of the boundary faces that are shown in the figures. In those places where the word "a(n)" is used, a number larger than one may be used, of course.

Possible variations on the method are the winding up of two foils at the same time. The foils may or may not come from two different rolls, for example. Furthermore, the foils may already be bonded. In addition, the foils may already be patterned. According to another variant, the foils do not have the same thickness. Furthermore, more than two foils may be wound up.

In the present description, the example of winding up a foil is extensively illustrated. It is also possible to stack separate foils, of course. In that situation it is also possible to stack foils that do not have the same thickness.

In addition, all the examples of the microsystem that have been described herein may comprise a number of foils different from the number mentioned herein. This depends in part on the designer's requirements.

## Claims

1. A method of manufacturing a microsystem (MI, PS, AC, MV, MP, MT) provided with a space (110, 310, 510, 710, 910, 1110), which method comprises the following steps:
- providing a set (S) of at least two electrically insulating flexible foils, wherein the individual foils have substantially the same thickness, and wherein a conductive layer is present on at least one side of at least one foil, and wherein said conductive layer is suitable for use as an electrode or a conductor;
- patterning the conductive layer so as to form an electrode or a conductor;
- patterning at least one foil, in such a manner that an opening is formed, which opening forms the space of the microsystem;
- stacking the set (S) of foils, thus forming the microsystem; and
- joining the foils together, with the foils being bonded together at those positions where, when two adjacent foils are in contact with each other, at least one conductive layer between the foil material of two adjacent foils has been removed, **characterised in** the that the stacking of the foils takes place by winding at least one foil (10) onto a first reel (70).

2. A method as claimed in claim 1, **characterized in that** a set (S) of foils is provided, with the individual foils comprising the same foil material.

3. A method as claimed in any one of the preceding claims, **characterized in that** at least three electrically insulating flexible foils are provided.

4. A method as claimed in any one of the preceding claims, **characterized in that** a movable element is formed of at least one foil in the microsystem, which movable element is attached to the microsystem on at least one side, wherein the movable element is selected from the group comprising a movable mass (500), a movable valve (770, 955, 965) and a movable membrane (100, 200, 300, 900), and wherein the movable element is present on one side of the space.

5. A method as claimed in any one of the preceding claims, **characterized in that** the microsystem is provided with a sensor (1170, 1180) that is formed in a conductive layer on a foil near said space for measuring a quantity in said space.

6. A method as claimed in any one of the preceding claims, **characterized in that** the microsystem to be manufactured comprises a microfluidic device.

7. A method as claimed in claim 1, **characterized in that** the microsystem that is manufactured is a microsystem from the group comprising a microvalve (MV), a micropump (MP) and a µTAS element (MT).

8. A method as claimed in any one of the preceding claims, **characterized in that** said patterning is carried out by means of a laser (L1, L2), whether or not in combination with a mask (20).

9. A method as claimed in claim **characterized in that** said patterning is carried out by using a selection from the following steps:
- leaving the conductive layer (11a) and the foil (10) in tact (A);
- removing the conductive layer (11a) so as to expose the foil (10) (B);
- removing the conductive layer (11a) and part of the foil (10), so that a thinner foil remains (C); and
- completely removing the conductive layer (11a, 11b) and the foil so as to form the space (D).

10. A method as claimed in claim 1, **characterized in that** the method is carried out in a process in which the foil (10) is unwound from a second reel or roll (80) upon being wound onto the first reel (70).

11. A method as claimed in claim 10, **characterized in that** said patterning of the conductive layer (11a) and the foil (10) takes place at at least one position selected from the following possibilities: on or near the first reel (L1), between the first and the second reel (L2), and on or near the second reel or roll (80).

12. A method as claimed in any one of the preceding claims, **characterized in that** said joining of the foils is carried out by exerting a pressure on the stacked foils at an elevated temperature, with the pressure being exerted in a direction perpendicular to the foils.

13. A method as claimed in claim 12, **characterized in that** the required pressure on the foils adjacent to the space in the structure is obtained through the application of an elevated pressure in said space.

14. A method as claimed in any one of the preceding claims, **characterized in that** an opening (130, 135) is formed in the stack of foils so as to provide access from one side of the microsystem to a conductive layer (121) that is connected to an electrode of the microsystem.

15. A method as claimed in any one of the preceding claims, **characterized in that** the microsystem is separated from the stack after fusion of the foils has taken place.

16. A method as claimed in any one of the preceding claims, **characterized in that** the material for the conductive layer is selected from the group comprising aluminum, platinum, silver, gold, copper, indium tin oxide, and magnetic materials.

17. A method as claimed in any one of the preceding claims, **characterized in that** the foil material is selected from the group comprising polyphenyl sulphide (PPS) and polyethylene terephthalate (PET).

18. A method as claimed in any one of the preceding claims, **characterized in that** the foil (10) that is used has a thickness between 1 µm and 5 µm.

## Patentansprüche

1. Verfahren zur Herstellung eines Mikrosystems (MI, PS, AC, MV, MP, MT), das mit einem Zwischenraum (110, 310, 510, 710, 910, 1110) versehen ist, wobei das Verfahren die folgenden Schritte umfasst, wonach:
- ein Satz (S) von mindestens zwei elektrisch isolierenden, flexiblen Folien vorgesehen wird, wobei die einzelnen Folien im Wesentlichen die gleiche Dicke aufweisen, und wobei eine leitende Schicht auf mindestens einer Seite von mindestens einer Folie vorhanden ist, und wobei die leitende Schicht zur Verwendung als eine Elektrode oder ein Leiter geeignet ist;
- die leitende Schicht strukturiert wird, um eine Elektrode oder einen Leiter auszubilden;
- mindestens eine Folie so strukturiert wird, dass eine Öffnung ausgebildet wird, die den Zwischenraum des Mikrosystems bildet;
- der Satz (S) von Folien gestapelt und somit das Mikrosystem gebildet wird; und
- die Folien miteinander verbunden werden, wobei die Folien durch Bonden an den Stellen zusammengefügt werden, an denen, wenn zwei aneinandergrenzende Folien in Kontakt miteinander sind, mindestens eine leitende Schicht zwischen dem Folienmaterial von zwei aneinandergrenzenden Folien entfernt wurde, **dadurch gekennzeichnet, dass** das Stapeln der Folien stattfindet, indem mindestens eine Folie (10) auf eine erste Spule (70) gewickelt wird.

2. Verfahren nach Anspruch 1, **dadurch gekennzeichnet, dass** ein Satz (S) von Folien vorgesehen wird, wobei die einzelnen Folien das gleiche Folienmaterial umfassen.

3. Verfahren nach einem der vorangegangenen Ansprüche, **dadurch gekennzeichnet, dass** mindestens drei elektrisch isolierende, flexible Folien vorgesehen werden.

4. Verfahren nach einem der vorangegangenen Ansprüche, **dadurch gekennzeichnet, dass** ein bewegbares Element aus mindestens einer Folie in dem Mikrosystem gebildet wird, das an dem Mikrosystem auf mindestens einer Seite angebracht wird, wobei das bewegbare Element aus der Gruppe, umfassend eine bewegbare Masse (500), ein bewegbares Ventil (770, 955, 965) und eine bewegbare Membran (100, 200, 300, 900), ausgewählt wird, und wobei das bewegbare Element auf einer Seite des Zwischenraums vorhanden ist.

5. Verfahren nach einem der vorangegangenen Ansprüche, **dadurch gekennzeichnet, dass** das Mikrosystem mit einem in einer leitenden Schicht auf einer Folie nahe dem Zwischenraum ausgebildeten Sensor (1170, 1180) zum Messen einer Quantität in dem Zwischenraum versehen ist.

6. Verfahren nach einem der vorangegangenen Ansprüche, **dadurch gekennzeichnet, dass** das herzustellende Mikrosystem eine mikrofluidische Anordnung umfasst.

7. Verfahren nach Anspruch 1, **dadurch gekennzeichnet, dass** das herzustellende Mikrosystem ein Mikrosystem aus der Gruppe, umfassend ein Mikroventil (MV), eine Mikropumpe (MP) sowie ein µTAS-Element (MT), ist.

8. Verfahren nach einem der vorangegangenen Ansprüche, **dadurch gekennzeichnet, dass** die Strukturierung mit Hilfe eines Lasers (L1, L2), ob in Kombination mit einer Maske (20) oder nicht, ausgeführt wird.

9. Verfahren nach Anspruch 8, **dadurch gekennzeichnet, dass** die Strukturierung unter Anwenden einer Auswahl aus den folgenden Schritten ausgeführt wird, wonach:
- die leitende Schicht (11a) und die Folie (10) intakt (A) gelassen werden;
- die leitende Schicht (11a) entfernt wird, um die Folie (10) freizulegen (B);
- die leitende Schicht (11a) und ein Teil der Folie (10) entfernt werden, so dass eine dünnere Folie verbleibt (C); und
- die leitende Schicht (11a, 11b) und die Folie vollständig entfernt werden, um den Zwischenraum (D) auszubilden.

10. Verfahren nach Anspruch 1, **dadurch gekennzeichnet, dass** das Verfahren in einem Prozess ausgeführt wird, in dem die Folie (10) nach Aufwickeln auf die erste Spule (70) von einer zweiten Spule oder Rolle (80) abgewickelt wird.

11. Verfahren nach Anspruch 10, **dadurch gekennzeichnet, dass** die Strukturierung der leitenden Schicht (11a) und der Folie (10) an mindestens einer Stelle stattfindet, die aus den folgenden Möglichkeiten ausgewählt wird: auf oder nahe der ersten Spule (L1), zwischen der ersten und der zweiten Spule (L2) sowie auf oder nahe der zweiten Spule oder Rolle (80).

12. Verfahren nach einem der vorangegangenen Ansprüche, **dadurch gekennzeichnet, dass** das Verbinden der Folien durch Ausüben eines Drucks auf die gestapelten Folien bei einer erhöhten Temperatur durchgeführt wird, wobei der Druck in einer Richtung senkrecht zu den Folien ausgeübt wird.

13. Verfahren nach Anspruch 12, **dadurch gekennzeichnet, dass** der erforderliche Druck auf den Folien in Angrenzung an den Zwischenraum in der Struktur durch das Anwenden eines erhöhten Drucks in dem Zwischenraum erreicht wird.

14. Verfahren nach einem der vorangegangenen Ansprüche, **dadurch gekennzeichnet, dass** eine Öffnung (130, 135) in dem Stapel von Folien ausgebildet wird, um von einer Seite des Mikrosystems Zugang zu einer leitenden Schicht (121), die mit einer Elektrode des Mikrosystems verbunden ist, zu ermöglichen.

15. Verfahren nach einem der vorangegangenen Ansprüche, **dadurch gekennzeichnet, dass** das Mikrosystem nach Stattfinden des Zusammenfügens der Folien von dem Stapel getrennt wird.

16. Verfahren nach einem der vorangegangenen Ansprüche, **dadurch gekennzeichnet, dass** das Material für die leitende Schicht aus der Gruppe, umfassend Aluminium, Platin, Silber, Gold, Kupfer, Indiumzinnoxid sowie magnetische Materialien, ausgewählt wird.

17. Verfahren nach einem der vorangegangenen Ansprüche, **dadurch gekennzeichnet, dass** das Folienmaterial aus der Gruppe, umfassend Polyphenylsulphid (PPS) und Polyethylenterephthalat (PET), ausgewählt wird.

18. Verfahren nach einem der vorangegangenen Ansprüche, **dadurch gekennzeichnet, dass** die Folie (10), die verwendet wird, eine Dicke zwischen 1 µm und 5 µm aufweist.

## Revendications

1. Procédé de fabrication d'un microsystème (MI, PS, AC, MV, MP, MT) doté d'un espace (110, 310, 510, 710, 910, 1110), ledit procédé comprenant les étapes suivantes :
- l'obtention d'un groupe (S) d'au moins deux feuilles flexibles électriquement isolantes, les feuilles individuelles possédant sensiblement la même épaisseur, une couche conductrice étant présente sur au moins une face d'au moins une feuille et ladite couche conductrice étant appropriée pour être utilisée comme électrode ou conducteur ;
- la formation d'un motif sur la couche conductrice afin de former une électrode ou un conducteur ;
- la formation d'un motif sur au moins une feuille, de façon à former une ouverture, ladite ouverture formant l'espace du microsystème ;
- l'empilement du groupe (S) de feuilles, pour ainsi former le microsystème ; et
- l'assemblage des feuilles, les feuilles étant liées ensemble à des positions où, quand deux feuilles adjacentes sont en contact l'une avec l'autre, au moins une couche conductrice entre le matériau de feuille de deux feuilles adjacentes a été retirée, **caractérisé en ce que** l'empilement des feuilles est réalisé par l'enroulement d'au moins une feuille (10) sur une première bobine (70).

2. Procédé selon la revendication 1, **caractérisé en ce qu'**un groupe (S) de feuilles est utilisé, les feuilles individuelles comprenant le même matériau de feuille.

3. Procédé selon l'une quelconque des revendications précédentes, **caractérisé en ce qu'**au moins trois feuilles flexibles électriquement isolantes sont utilisées.

4. Procédé selon l'une quelconque des revendications précédentes, **caractérisé en ce qu'**un élément mobile est formé d'au moins une feuille dans le microsystème, ledit élément mobile étant fixé au microsystème sur au moins une face, dans lequel l'élément mobile est choisi dans le groupe comprenant une masse mobile (500), une valve mobile (770, 955, 965) et une membrane mobile (100, 200, 300, 900), et dans lequel l'élément mobile est présent d'un côté de l'espace.

5. Procédé selon l'une quelconque des revendications précédentes, **caractérisé en ce que** le microsystème est doté d'un capteur (1170, 1180) qui est formé dans une couche conductrice sur une feuille à proximité dudit espace pour mesurer une quantité dans ledit espace.

6. Procédé selon l'une quelconque des revendications précédentes, **caractérisé en ce que** le microsystème à fabriquer comprend un dispositif microfluidique.

7. Procédé selon la revendication 1, **caractérisé en ce que** le microsystème qui est fabriqué est un microsystème choisi dans le groupe comprenant une microvalve (MV), une micropompe (MP) et un élément µTAS (MT).

8. Procédé selon l'une quelconque des revendications précédentes, **caractérisé en ce que** ladite formation de motif est réalisée au moyen d'un laser (L1, L2), en combinaison ou non avec un masque (20).

9. Procédé selon la revendication 8, **caractérisé en ce que** ladite formation de motif est réalisée en utilisant une sélection parmi les étapes suivantes :
- laisser la couche conductrice (11a) et la feuille (10) intactes (A) ;
- retirer la couche conductrice (11a) afin d'exposer la feuille (10) (B) ;
- retirer la couche conductrice (11a) et une partie de la feuille (10), de façon à ce qu'une feuille plus fine reste (C) ; et
- retirer totalement la couche conductrice (11a, 11b) et la feuille afin de former l'espace (D).

10. Procédé selon la revendication 1, **caractérisé en ce que** le procédé est mis en oeuvre dans un procédé dans lequel la feuille (10) est déroulée à partir d'une seconde bobine ou d'un second rouleau (80) lorsqu'elle s'enroule sur la première bobine (70).

11. Procédé selon la revendication 10, **caractérisé en ce que** ladite formation de motif sur la couche conductrice (11a) et la feuille (10) est réalisée sur au moins une position choisie parmi les possibilités suivantes : sur ou à proximité de la première bobine (L1), entre la première et la seconde bobine (L2) et sur ou à proximité de la seconde bobine ou du second rouleau (80).

12. Procédé selon l'une quelconque des revendications précédentes, **caractérisé en ce que** ledit assemblage des feuilles est réalisé en exerçant une pression sur les feuilles empilées à température élevée, la pression étant exercée dans une direction perpendiculaire aux feuilles.

13. Procédé selon la revendication 12, **caractérisé en ce que** la pression nécessaire sur les feuilles adjacentes à l'espace dans la structure est obtenue par l'application d'une pression élevée dans ledit espace.

14. Procédé selon l'une quelconque des revendications précédentes, **caractérisé en ce qu'**une ouverture (130, 135) est formée dans l'empilement de feuilles afin de fournir un accès à partir d'un côté du microsystème vers une couche conductrice (121) qui est connectée à une électrode du microsystème.

15. Procédé selon l'une quelconque des revendications précédentes, **caractérisé en ce que** le microsystème est séparé de l'empilement après que la fusion des feuilles a eu lieu.

16. Procédé selon l'une quelconque des revendications précédentes, **caractérisé en ce que** le matériau de la couche conductrice est choisi dans le groupe comprenant l'aluminium, le platine, l'argent, l'or, le cuivre, l'oxyde d'étain et d'indium et les matériaux magnétiques.

17. Procédé selon l'une quelconque des revendications précédentes, **caractérisé en ce que** le matériau de feuille est choisi dans le groupe comprenant un poly(sulfure de phényle) (PPS) et un poly(téréphtalate d'éthylène) (PET).

18. Procédé selon l'une quelconque des revendications précédentes, **caractérisé en ce que** la feuille (10) qui est utilisée possède une épaisseur située entre 1 µm et 5 µm.
